(19) Europäisches Patentamt / European Patent Office / Office européen des brevets

(11) **EP 3 813 130 A1**

(12) **EUROPEAN PATENT APPLICATION**
published in accordance with Art. 153(4) EPC

(43) Date of publication:
28.04.2021 Bulletin 2021/17

(51) Int Cl.:
*H01L 35/08* (2006.01)   *H01L 35/34* (2006.01)

(21) Application number: 19822343.0

(22) Date of filing: 10.06.2019

(86) International application number:
PCT/JP2019/022915

(87) International publication number:
WO 2019/244692 (26.12.2019 Gazette 2019/52)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 19.06.2018 JP 2018115920

(71) Applicant: Mitsubishi Materials Corporation
Tokyo 100-8117 (JP)

(72) Inventors:
• ARAI, Koya
Saitama-shi, Saitama 330-8508 (JP)
• KOMASAKI, Masahito
Saitama-shi, Saitama 330-8508 (JP)
• NAGATOMO, Yoshiyuki
Saitama-shi, Saitama 330-8508 (JP)

(74) Representative: Hoffmann Eitle
Patent- und Rechtsanwälte PartmbB
Arabellastraße 30
81925 München (DE)

(54) **THERMOELECTRIC CONVERSION MODULE AND METHOD FOR MANUFACTURING THERMOELECTRIC CONVERSION MODULE**

(57)   A thermoelectric conversion module includes: a plurality of thermoelectric conversion elements (11); a first electrode portion (25) disposed on one end side of the plurality of thermoelectric conversion elements (11); and a second electrode portion (35) disposed on the other end side of the plurality of thermoelectric conversion elements (11), a first insulating circuit board (20) provided with a first insulating layer (21) and the first electrode portion (25) made of copper or a copper alloy formed on one surface of the first insulating layer (21) is disposed on one end side of the thermoelectric conversion elements (11), a Ag plating layer (26) is directly formed on a surface of the first electrode portion (25) opposite to the first insulating layer (21), a Ni layer is not present between the first electrode portion (25) and the Ag plating layer (26), and the Ag plating layer (26) and the thermoelectric conversion element (11) are bonded to each other via a sintered body (28) of Ag.

FIG. 1

**Description**

TECHNICAL FIELD

This invention relates to a thermoelectric conversion module in which a plurality of thermoelectric conversion elements are electrically connected to each other, and a method for producing a thermoelectric conversion module.
Priority is claimed on Japanese Patent Application No. 2018-115920, filed on June 19, 2018, the content of which is incorporated herein by reference.

BACKGROUND ART

A thermoelectric conversion element is an electronic element that enables conversion between thermal energy and electric energy by the Seebeck effect or the Peltier effect.
The Seebeck effect is a phenomenon in which an electromotive force is generated when a temperature difference is generated between both ends of a thermoelectric conversion element, and thermal energy is converted into electric energy. The electromotive force generated by the Seebeck effect is determined by the characteristics of the thermoelectric conversion element. In recent years, thermoelectric power generation utilizing this effect has been actively developed.
The Peltier effect is a phenomenon in which a temperature difference is generated at both ends of a thermoelectric conversion element when an electrode or the like is formed at both ends of the thermoelectric conversion element and a potential difference is generated between the electrodes, and electric energy is converted into thermal energy. An element having this effect is particularly called a Peltier element, and is used for cooling and temperature control of precision instruments and small refrigerators.
As a thermoelectric conversion module using the above-described thermoelectric conversion element, for example, a structure in which n-type thermoelectric conversion elements and p-type thermoelectric conversion elements are alternately connected in series has been proposed.
Such a thermoelectric conversion module has a structure in which a heat transfer plate is disposed on each of one end side and the other end side of a plurality of thermoelectric conversion elements, and the thermoelectric conversion elements are connected in series by electrode portions disposed in the heat transfer plates. As the above-described heat transfer plate, an insulating circuit board provided with an insulating layer and the electrode portion may be used.
In addition, electric energy can be generated by the Seebeck effect by generating a temperature difference between the heat transfer plate disposed on one end side of the thermoelectric conversion elements and the heat transfer plate disposed on the other end side of the thermoelectric conversion elements. Alternatively, by applying a current to the thermoelectric conversion elements, a temperature difference between the heat transfer plate provided on one end side of the thermoelectric conversion elements and the heat transfer plate provided on the other end side of the thermoelectric conversion elements can be generated by the Peltier effect.
Here, as the insulating circuit board used in the above-described thermoelectric conversion module, for example, as shown in Patent Documents 1 and 2, one in which an electrode is formed by bonding a copper plate to the surface of a ceramic substrate by a DBC method or the like (so-called DBC substrate) has been proposed.
In this DBC substrate, a Ni plating layer is usually formed on the surface of an electrode formed of the copper plate, and a thermoelectric conversion elements are bonded thereto via a bonding material such as solder or Ag paste.

[Citation List]

[Patent Document]

[Patent Document 1]
Japanese Patent No. 4363958
[Patent Document 2]
Japanese Unexamined Patent Application, First Publication No. 2010-109054

SUMMARY OF INVENTION

Technical Problem

Here, in the thermoelectric conversion module using the DBC substrate described in Patent Documents 1 and 2, when the thermoelectric conversion module is placed in a high temperature field in the air atmosphere, the Ni plating layer is oxidized to generate an insulating nickel oxide, and there is concern that the electric resistance at the bonding interface between the thermoelectric conversion element and the electrode may increase.

Therefore, it is difficult to stably maintain excellent thermoelectric efficiency in use under high temperature conditions.

This invention has been made in view of the above-described circumstances, and an object thereof is to provide a thermoelectric conversion module capable of suppressing an increase in electric resistance at the bonding interface between a thermoelectric conversion element and an electrode portion even in use under the condition that temperature cycles are applied, suppressing an increase in the internal resistance of the thermoelectric conversion module, and stably maintaining excellent thermoelectric efficiency, and a method for producing a thermoelectric conversion module.

Solution to Problem

In order to solve the above problems, a thermoelectric conversion module of the present invention is a thermoelectric conversion module including: a plurality of thermoelectric conversion elements; a first heat transfer plate having a first electrode portion disposed on one end side of the plurality of thermoelectric conversion elements; and a second heat transfer plate having a second electrode portion disposed on the other end side of the plurality of thermoelectric conversion elements, in which the plurality of the thermoelectric conversion elements are electrically connected to each other via the first electrode portion and the second electrode portion, the first heat transfer plate disposed on one end side of the thermoelectric conversion elements is formed from a first insulating circuit board provided with a first insulating layer and the first electrode portion made of copper or a copper alloy formed on one surface of the first insulating layer, a Ag plating layer is directly formed on a surface of the first electrode portion opposite to the first insulating layer, and a Ni layer is not present between the first electrode portion and the Ag plating layer, and the Ag plating layer and the thermoelectric conversion element are bonded to each other via a sintered body of Ag.

According to the thermoelectric conversion module of the present invention, since the Ag plating layer is directly formed on the surface of the first electrode portion opposite to the first insulating layer, no Ni layer is present between the first electrode portion and the Ag plating layer, and the Ag plating layer and the thermoelectric conversion element are bonded to each other via the sintered body of Ag, even in use under the condition that temperature cycles are applied, no insulating nickel oxide is generated between the thermoelectric conversion element and the first electrode portion, an increase in electric resistance at the bonding interface between the thermoelectric conversion element and the electrode portion can be suppressed, an increase in the internal resistance of the thermoelectric conversion module can be suppressed, and excellent thermoelectric efficiency can be stably maintained.

In addition, the bonding between the Ag plating layer and the sintered body of Ag is good, and the first electrode portion and the thermoelectric conversion element can be reliably bonded to each other.

Here, in the thermoelectric conversion module of the present invention, it is preferable that an internal resistance increase rate of the thermoelectric conversion module is 60% or less after applying 100 thermal cycles from 450°C to 150°C to the first heat transfer plate side while the second heat transfer plate side is fixed at 80°C in the air.

In this case, since the internal resistance increase rate of the thermoelectric conversion module is 60% or less after applying 100 thermal cycles from 450°C to 150°C to the first heat transfer plate side, even in a case where the temperature cycles are applied to the first heat transfer plate side, excellent thermoelectric efficiency can be stably maintained.

The internal resistance increase rate $P$ is calculated by the following formula from an initial internal resistance $R_0$, and an internal resistance $R_1$ of the thermoelectric conversion module after 100 thermal cycles from 450°C to 150°C are applied to the first heat transfer plate side while the second heat transfer plate side is fixed at 80°C.

$$P = ((R_1 - R_0)/R_0 \times 100) \ (\%)$$

A method for producing a thermoelectric conversion module of the present invention is a method for producing a thermoelectric conversion module, in which the thermoelectric conversion module includes a plurality of thermoelectric conversion elements, a first heat transfer plate having a first electrode portion disposed on one end side of the plurality of thermoelectric conversion elements, and a second heat transfer plate having a second electrode portion disposed on the other end side of the plurality of thermoelectric conversion elements, the plurality of the thermoelectric conversion elements are electrically connected to each other via the first electrode portion and the second electrode portion, and the first heat transfer plate disposed on one end side of the thermoelectric conversion elements is formed from a first insulating circuit board provided with a first insulating layer and the first electrode portion made of copper or a copper alloy formed on one surface of the first insulating layer, the method including: a Ag plating step of directly forming a Ag plating layer on a surface of the first electrode portion opposite to the first insulating layer without forming a Ni plating layer; a laminating step of laminating the thermoelectric conversion element on a surface of the Ag plating layer of the first insulating circuit board via a Ag bonding material containing Ag; and a thermoelectric conversion element bonding step of bonding the thermoelectric conversion element by pressurizing the thermoelectric conversion element and the first insulating circuit board in a lamination direction and heating the thermoelectric conversion element and the first insulating circuit board.

According to the method for producing a thermoelectric conversion module having such a configuration, since the Ag plating step of directly forming the Ag plating layer on the surface of the first electrode portion opposite to the first insulating layer without forming a Ni plating layer is included, it is possible to produce the thermoelectric conversion module which has no Ni layer present between the first electrode portion and the Ag plating layer, does not generate insulating nickel oxide between the thermoelectric conversion element and the first electrode portion even in use under the condition that temperature cycles are applied, and is capable suppressing an increase in the electric resistance at the bonding interface between the thermoelectric conversion element and the electrode portion, suppressing an increase in the internal resistance of the thermoelectric conversion module, and stably maintaining excellent thermoelectric efficiency.

Furthermore, since the Ag plating layer formed on the surface of the first electrode portion and the thermoelectric conversion element are bonded to each other via the Ag bonding material containing Ag, it is possible to reliably bond the first electrode portion and the thermoelectric conversion element to each other.

Advantageous Effects of Invention

According to the present invention, it is possible to provide a thermoelectric conversion module capable of suppressing an increase in electric resistance at the bonding interface between a thermoelectric conversion element and an electrode portion even in use under the condition that temperature cycles are applied, suppressing an increase in the internal resistance of the thermoelectric conversion module, and stably maintaining excellent thermoelectric efficiency, and a method for producing a thermoelectric conversion module.

BRIEF DESCRIPTION OF DRAWINGS

Fig. 1 is a schematic explanatory view of a thermoelectric conversion module according to an embodiment of the present invention.
Fig. 2 is an enlarged explanatory view of a bonding interface between an electrode portion and a thermoelectric conversion element in the thermoelectric conversion module according to the embodiment of the present invention.
Fig. 3 is a flowchart showing a method for producing a thermoelectric conversion module according to the embodiment of the present invention.
Fig. 4 is a schematic explanatory view of the method for producing a thermoelectric conversion module according to the embodiment of the present invention, where (a-1), (b-1), and (c-1), and (a-2), (b-2), and (c-2) are a copper plate bonding step, (d-1) and (d-2) are a Ag plating layer forming step, and (e-1) and (e-2) are a Ag bonding material disposing step.
Fig. 5 is a schematic explanatory view of the method for producing a thermoelectric conversion module according to the embodiment of the present invention, where (a) is a laminating step and a thermoelectric conversion element bonding step, (b) shows the obtained thermoelectric conversion module.
Fig. 6 is a schematic explanatory view of a thermoelectric conversion module according to another embodiment of the present invention.
Fig. 7 is a diagram showing a relationship between the number of thermal cycles and electric resistance in an example.
Fig. 8A is a diagram showing an observation result of an interface of a comparative example in the example.
Fig. 8B is a diagram showing an observation result of an interface of an example of the present invention in an example.

DESCRIPTION OF EMBODIMENTS

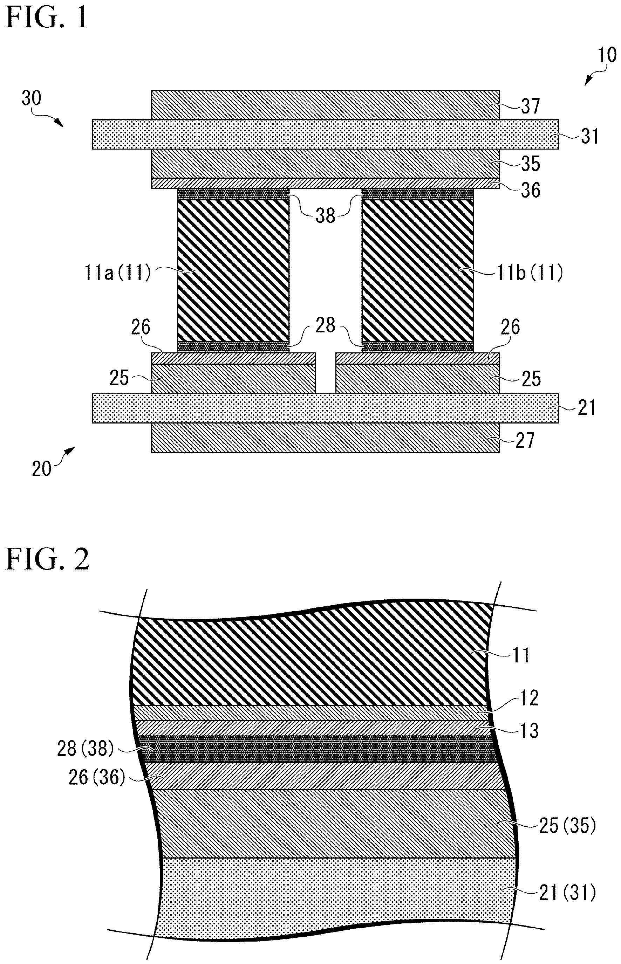

Hereinafter, embodiments of the present invention will be described with reference to the accompanying drawings. Each embodiment to be described below is specifically described for better understanding of the gist of the invention, and does not limit the present invention unless otherwise specified. In addition, in the drawings used in the following description, for convenience, in order to make the features of the present invention easy to understand, a portion that is a main part may be enlarged in some cases, and a dimensional ratio or the like of each component is not always the same as an actual one.
As illustrated in Fig. 1, a thermoelectric conversion module 10 according to the present embodiment includes a plurality of columnar thermoelectric conversion elements 11, a first heat transfer plate 20 disposed on one end side (lower side in Fig. 1) of the thermoelectric conversion elements 11 in a longitudinal direction thereof, and a second heat transfer plate 30 disposed on the other end side (upper side in Fig. 1) of the thermoelectric conversion elements 11 in the longitudinal direction.

Here, as illustrated in Fig. 1, a first electrode portion 25 is formed in the first heat transfer plate 20 provided on the one end side of the thermoelectric conversion elements 11, a second electrode portion 35 is formed in the second heat transfer plate 30 provided on the other end side of the thermoelectric conversion elements 11, and the plurality of columnar thermoelectric conversion elements 11 are electrically connected in series by the first and second electrode portions 25 and 35.

The first heat transfer plate 20 is formed from a first insulating circuit board provided with a first insulating layer 21 and the first electrode portion 25 formed on one surface (the upper surface in Fig. 1) of the first insulating layer 21.

In the present embodiment, in the first insulating circuit board that becomes the first heat transfer plate 20, as illustrated in Fig. 1, a first radiating layer 27 is formed on the other surface (the lower surface in Fig. 1) of the first insulating layer 21.

The first insulating layer 21 is made of a highly insulating ceramic material such as aluminum nitride (AlN), silicon nitride ($Si_3N_4$), and alumina ($Al_2O_3$), or an insulating resin. In the present embodiment, the first insulating layer 21 is made of aluminum nitride (AlN).

Here, the thickness of the first insulating layer 21 made of aluminum nitride is in a range of 100 $\mu$m or more and 2000 $\mu$m or less.

The first electrode portion 25 is made of copper or a copper alloy, and a first Ag plating layer 26 is formed on the surface of the first electrode portion 25 opposite to the first insulating layer 21.

The first electrode portion 25 is formed in a pattern on the one surface (the upper surface in Fig. 1) of the first insulating layer 21. The first Ag plating layer 26 is directly formed on the surface of the first electrode portion 25, and no Ni plating layer or the like is interposed therebetween.

Here, the first electrode portion 25 has a thickness in a range of 50 $\mu$m or more and 1000 $\mu$m or less.

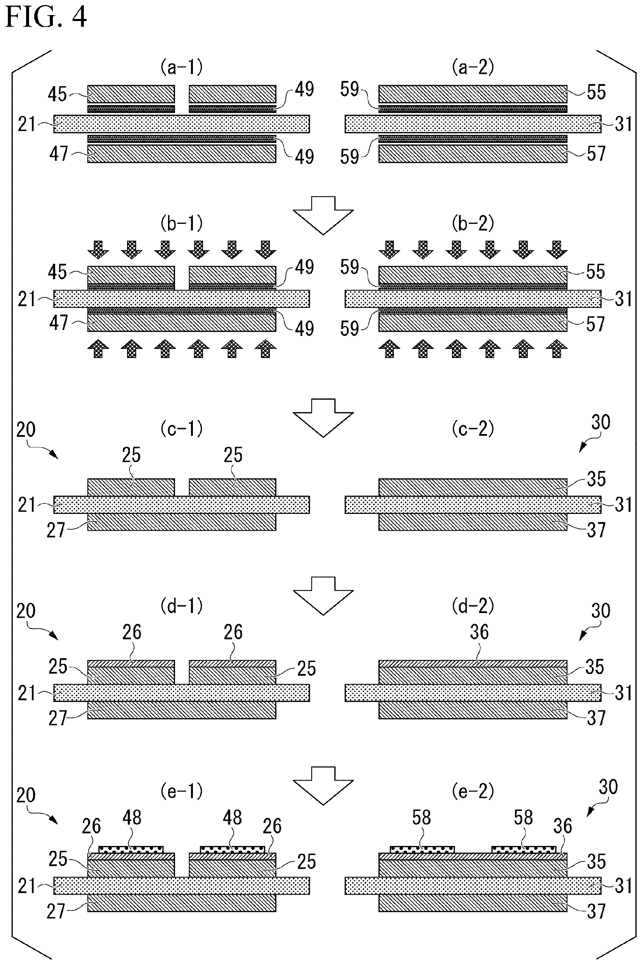

In addition, as illustrated in Fig. 4, the first electrode portion 25 is formed by bonding a first copper plate 45 to one surface of the first insulating layer 21. The first copper plate 45 is made of copper or a copper alloy. In the present embodiment, the first copper plate 45 is a rolled plate of oxygen-free copper.

The first Ag plating layer 26 is directly formed on the surface of the first electrode portion 25, and has a thickness in range of 0.1 $\mu$m or more and 10 $\mu$m or less.

In the present embodiment, as illustrated in Fig. 1, the first Ag plating layer 26 is formed on the entire surface of the first electrode portion 25 opposite to the first insulating layer 21.

The first radiating layer 27 is made of copper or a copper alloy. In the present embodiment, as illustrated in Fig. 4, the first radiating layer 27 is formed by bonding a radiating copper plate 47 to the other surface of the first insulating layer 21. In the present embodiment, the radiating copper plate 47 is a rolled plate of oxygen-free copper.

In the present embodiment, the first radiating layer 27 has a thickness in a range of 50 $\mu$m or larger and 1000 $\mu$m or less.

The second heat transfer plate 30 is formed from a second insulating circuit board provided with a second insulating layer 31 and the second electrode portion 35 formed on one surface (the lower surface in Fig. 1) of the second insulating layer 31.

In the present embodiment, in the second insulating circuit board that becomes the second heat transfer plate 30, as illustrated in Fig. 1, a second radiating layer 37 is formed on the other surface (the upper surface in Fig. 1) of the second insulating layer 31.

The second insulating layer 31 is made of a highly insulating ceramic material such as aluminum nitride (AlN), silicon nitride ($Si_3N_4$), and alumina ($Al_2O_3$), or an insulating resin. In the present embodiment, the second insulating layer 31 is made of aluminum nitride (AlN).

Here, the second insulating layer 31 made of aluminum nitride has a thickness in a range of 100 $\mu$m or more and 2000 $\mu$m or less.

The second electrode portion 35 is made of copper or a copper alloy, and a second Ag plating layer 36 is formed on the surface of the second electrode portion 35 opposite to the second insulating layer 31.

The second electrode portion 35 is formed in a pattern on the one surface (the lower surface in Fig. 1) of the second insulating layer 31. The second Ag plating layer 36 is directly formed on the surface of the second electrode portion 35, and no Ni plating layer or the like is interposed therebetween.

Here, the second electrode portion 35 has a thickness in a range of 50 $\mu$m or more and 1000 $\mu$m or less.

In addition, as illustrated in Fig. 4, the second electrode portion 35 is formed by bonding a second copper plate 55 to one surface of the second insulating layer 31. The second copper plate 55 is made of copper or a copper alloy. In the present embodiment, the second copper plate 55 is a rolled plate of oxygen-free copper.

The second Ag plating layer 36 is directly formed on the surface of the second electrode portion 35, and has a thickness in range of 0.1 μm or more and 10 μm or less.

In the present embodiment, as illustrated in Fig. 1, the second Ag plating layer 36 is formed on the entire surface of the second electrode portion 35 opposite to the second insulating layer 31.

The second radiating layer 37 is made of copper or a copper alloy. In the present embodiment, as illustrated in Fig. 4, the second radiating layer 37 is formed by bonding a radiating copper plate 57 to the other surface of the second insulating layer 31. In the present embodiment, the radiating copper plate 57 is a rolled plate of oxygen-free copper.

In the present embodiment, the second radiating layer 37 has a thickness in a range of 50 μm or larger and 1000 μm or less.

The thermoelectric conversion element 11 includes an n-type thermoelectric conversion element 11a and a p-type thermoelectric conversion element 11b, and these n-type thermoelectric conversion element 11a and p-type thermoelectric conversion element 11b are alternately arranged.

For example, the n-type thermoelectric conversion element 11a and the p-type thermoelectric conversion element 11b are formed of sintered bodies of tellurium compounds, skutterudites, filled skutterudites, Heuslers, half-Heuslers, clathrates, silicides, oxides, or silicon-germanium.

As a material of the n-type thermoelectric conversion element 11a, for example, $Bi_2Te_3$, PbTe, $La_3Te_4$, $CoSb_3$, FeVAl, ZrNiSn, $Ba_8Al_{16}Si_{30}$, $Mg_2Si$, $FeSi_2$, $SrTiO_3$, $CaMnO_3$, ZnO, or SiGe is used.

In addition, as a material of the p-type thermoelectric conversion element 11b, for example, $Bi_2Te_3$, Sb2Te3, PbTe, TAGS (= Ag-Sb-Ge-Te), $Zn_4Sb_3$, CoSb3, $CeFe_4Sb_{12}$, $Yb_{14}MnSb_{11}$, FeVAl, $MnSi_{1.73}$, $FeSi_2$, $NaxCoO_2$ $Ca_3Co_4O_7$, $Bi_2Sr_2Co_2O_7$, or SiGe is used.

There are a compound that can take both n-type and p-type by a dopant, and a compound that has only one of n-type and p-type properties.

Here, the structure of the bonding interface between the electrode portions (the first electrode portion 25 and the second electrode portion 35) and the thermoelectric conversion element 11 will be described with reference to Fig. 2.

The electrode portions (the first electrode portion 25 and the second electrode portion 35) and the thermoelectric conversion element 11 are bonded together via an Ag bonding material containing Ag. In the present embodiment, a Ag paste containing Ag particles is used as the Ag bonding material.

As illustrated in Fig. 2, metallized layers 12 are respectively formed on one end surface and the other end surface of the thermoelectric conversion element 11. As the metallized layer 12, for example, silver, cobalt, tungsten, molybdenum, or a nonwoven fabric made of fibers of such metals can be used. Furthermore, a noble metal layer 13 made of Au or Ag is formed on the outermost surface of the metallized layer 12 (bonding surface to the first electrode portion 25 and the second electrode portion 35).

A first sintered silver layer 28 made of a sintered body of a Ag paste 48 is formed between the first Ag plating layer 26 formed on the first electrode portion 25 and the noble metal layer 13 formed on one end surface of the thermoelectric conversion element 11, and a second sintered silver layer 38 made of a sintered body of a Ag paste 58 is formed between the second Ag plating layer 36 formed on the second electrode portion 35 and the noble metal layer 13 formed on the other end surface of the thermoelectric conversion element 11.

Here, in the present embodiment, it is preferable that the internal resistance increase rate of the thermoelectric conversion module 10 after 100 thermal cycles between 450°C and 150°C are applied to the first heat transfer plate 20 side while the second heat transfer plate 30 side is fixed at 80°C in the air is 60% or less.

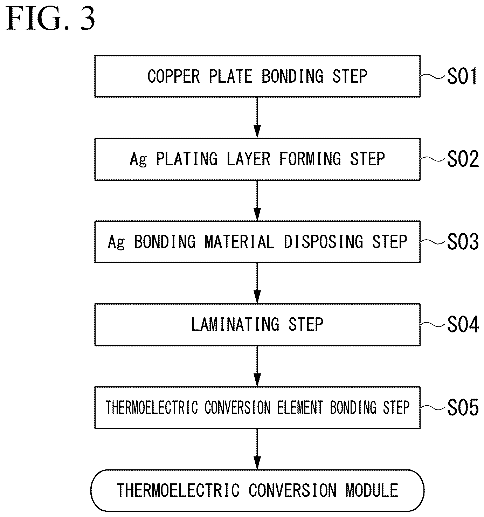

Next, a method for producing the thermoelectric conversion module 10, which is the present embodiment described above, will be described with reference to Figs. 3 to 5.

(Copper Plate Bonding Step S01)

First, as illustrated in Fig. 4, the first copper plate 45 is bonded to one surface of the first insulating layer 21 to form the first electrode portion 25 ((a-1), (b-1), and (c-1) in Fig. 4), and the second copper plate 55 is bonded to one surface of the second insulating layer 31 to form the second electrode portion 35 ((a-2), (b-2), and (c-2) in Fig. 4).

In the present embodiment, as illustrated in Fig. 4, the first radiating layer 27 is formed by bonding the radiating copper plate 47 to the other surface of the first insulating layer 21 ((a-1), (b-1), and (c-1) in Fig. 4), and the second radiating layer 37 is formed by bonding the radiating copper plate 57 to the other surface of the second insulating layer 31 ((a-2), (b-2), and (c-2) in Fig. 4).

Here, a method for bonding the first insulating layer 21 to the first copper plate 45 and the radiating copper plate 47, and a method for bonding the second insulating layer 31 to the second copper plate 55 and the radiating copper plate 57 are not particularly limited, and for example, an active metal brazing method using a Ag-Cu-Ti-based brazing material or a DBC method may be applied.

In the present embodiment, as illustrated in Fig. 4, Ag-Cu-Ti-based brazing materials 49 and 59 are used to bond the first insulating layer 21 to the first copper plate 45 and the radiating copper plate 47 ((a-1), (b-1), and (c-1) in Fig. 4), and the second insulating layer 31 to the second copper plate 55 and the radiating copper plate 57 ((a-2), (b-2), and (c-2) in Fig. 4).

Specifically, as illustrated in (a-1) and (a-2) in Fig. 4, the Ag-Cu-Ti-based brazing material 49 is disposed between the first insulating layer 21 and each of the first copper plate 45 and the radiating copper plate 47, and the Ag-Cu-Ti-based brazing material 59 is disposed between the second insulating layer 31 and each of the second copper plate 55 and the radiating copper plate 57. Next, as illustrated in (b-1) and (b-2) in Fig. 4, the first insulating layer 21, the first copper plate 45, and the radiating copper plate 47, and the second insulating layer 31, the second copper plate 55, and the radiating copper plate 57 are thermocompression-bonded or pressure-bonded via the Ag-Cu-Ti-based brazing materials 49 and 59. As a result, as illustrated in (c-1) and (c-2) in Fig. 4, the first electrode portion 25 is formed on one surface of the first insulating layer 21, the first radiating layer 27 is formed on the other surface of the first insulating layer 21, the second electrode portion 35 is formed on one surface of the second insulating layer 31, and the second radiating layer 37 is formed on the other surface of the second insulating layer 31.

(Ag Plating Layer Forming Step S02)

Next, the first Ag plating layer 26 is formed on one surface of the first electrode portion 25 ((d-1) in Fig. 4), and the second Ag plating layer 36 ((d-2) in Fig. 4) is formed on one surface of the second electrode portion 35.

The plating method is not particularly limited, and an electroplating method, an electroless plating method, or the like may be applied.

(Ag Bonding Material Disposing Step S03)

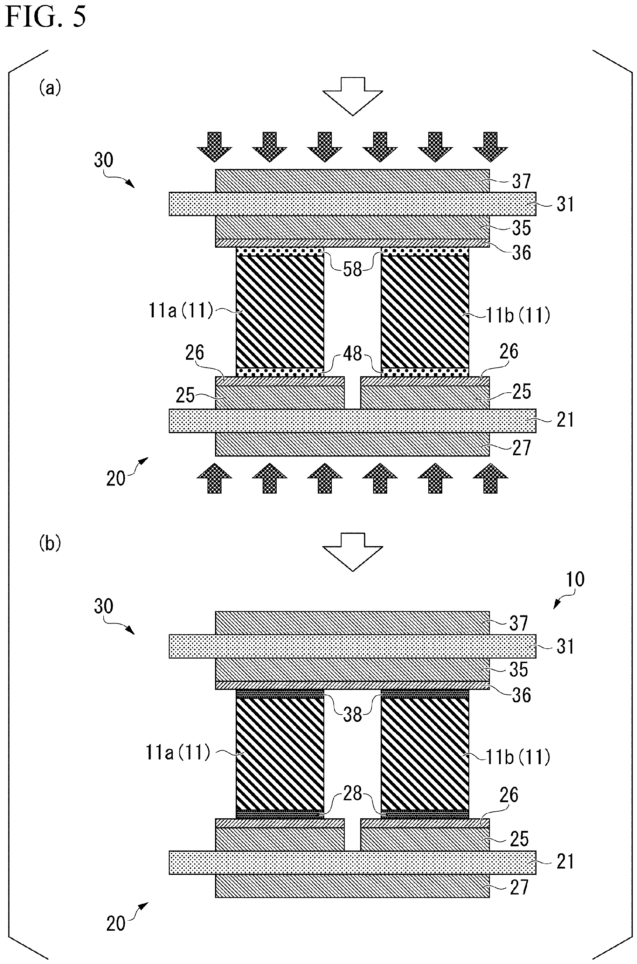

Next, the Ag pastes 48 and 58 which are Ag bonding materials are applied to the surfaces of the first Ag plating layer 26 and the second Ag plating layer 36 ((e-1) and (e-2) in Fig. 4). In addition, in the present embodiment, as illustrated in Figs. 4 and 5, the Ag pastes 48 and 58 are partially applied only to regions where the thermoelectric conversion elements 11 are disposed.

The application thickness of the Ag pastes 48 and 58 may be in a range of 1 $\mu$m or more and 100 $\mu$m or less.

Here, the Ag pastes 48 and 58 described above contain Ag powder and a solvent. A resin and a dispersant may further be contained therein as needed. The Ag powder contained in the Ag pastes 48 and 58 preferably has an average particle size in a range of 0.1 $\mu$m or more and 20 $\mu$m or less. Furthermore, the Ag pastes 48 and 58 may have a viscosity in a range of 10 Pa·s or more and 100 Pa·s or less.

(Laminating Step S04)

Next, the first heat transfer plate 20 is laminated on one end side (lower side in Fig. 5) of the thermoelectric conversion element 11 via the Ag paste 48, and the second heat transfer plate 30 is laminated on the other end side (upper side in Fig. 5) of the thermoelectric conversion element 11 via the Ag paste 58 ((a) in Fig. 5).

(Thermoelectric Conversion Element Bonding Step S05)

Next, the first heat transfer plate 20, the thermoelectric conversion elements 11, and the second heat transfer plate 30 are pressurized in the lamination direction and heated, and the Ag pastes 48 and 58 are sintered, whereby the thermoelectric conversion element 11 and the first electrode portion 25, and the thermoelectric conversion element 11 and the second electrode portion 35 are bonded ((b) in Fig. 5).

In this thermoelectric conversion element bonding step S05, the pressurization load is in a range of 10 MPa or more and 50 MPa or less, and the heating temperature is in a range of 300°C or higher and 400°C or lower. In the present embodiment, the holding time at the heating temperature mentioned above is in a range of 5 minutes or longer and 60 minutes or shorter, and the atmosphere is an air atmosphere.

As described above, the thermoelectric conversion module 10 according to the present embodiment is produced.

In the thermoelectric conversion module 10 of the present embodiment obtained as above, for example, the first heat transfer plate 20 is disposed in a high temperature field (for example, in a range of 200°C or higher and 450°C or lower) for use, the second heat transfer plate 30 is disposed in a low temperature field (for example, in a range of 10°C or higher and 80°C or lower) for use, and conversion between thermal energy and electric energy is performed.

In the thermoelectric conversion module 10 according to the present embodiment configured as described above, the first Ag plating layer 26 is directly formed on the surface of the first electrode portion 25 opposite to the first insulating layer 21, no Ni layer is present between the first electrode portion 25 and the first Ag plating layer 26, and the first Ag plating layer 26 and the thermoelectric conversion element 11 are bonded to each other via the first sintered silver layer 28 made of a sintered body of the Ag paste 48. Therefore, even in use under high temperature conditions, no insulating nickel oxide is generated between the thermoelectric conversion element 11 and the first electrode portion 25, and an increase in electric resistance at the bonding interface between the thermoelectric conversion element 11 and the first electrode portion 25 can be suppressed, so that it is possible to stably maintain excellent thermoelectric efficiency.

In addition, the bonding between the first Ag plating layer 26 and the first sintered silver layer 28 is good, and the first electrode portion 25 and the thermoelectric conversion element 11 can be reliably bonded to each other.

Furthermore, in the present embodiment, the second Ag plating layer 36 is directly formed on the surface of the second electrode portion 35 opposite to the second insulating layer 31, no Ni layer is present between the second electrode portion 35 and the second Ag plating layer 36, and the second Ag plating layer 36 and the thermoelectric conversion element 11 are bonded to each other via the second sintered silver layer 38 made of a sintered body of the Ag paste 58. Therefore, even in use under high temperature conditions, no insulating nickel oxide is generated between the thermoelectric conversion element 11 and the second electrode portion 35, and an increase in electric resistance at the bonding interface between the thermoelectric conversion element 11 and the second electrode portion 35 can be suppressed, so that it is possible to stably maintain excellent thermoelectric efficiency.

In addition, the bonding between the second Ag plating layer 36 and the second sintered silver layer 38 is good, and the second electrode portion 35 and the thermoelectric conversion element 11 can be reliably bonded to each other.

Furthermore, in the present embodiment, in a case where the internal resistance increase rate of the thermoelectric conversion module 10 after 100 thermal cycles between 450°C and 150°C are applied to the first heat transfer plate 20 side while the second heat transfer plate 30 side is fixed at 80°C in the air is 60% or less, even in a case where a temperature cycle is applied to the first heat transfer plate 20 side, it is possible to stably maintain excellent thermoelectric efficiency.

Moreover, according to the method for producing the thermoelectric conversion module 10 of the present embodiment, since the Ag plating layer forming step S02 of directly forming the first Ag plating layer 26 on the surface of the first electrode portion 25 opposite to the first insulating layer 21 without forming a Ni plating layer is included, it is possible to produce the thermoelectric conversion module 10 having no Ni layer present between the first electrode portion 25 and the first Ag plating layer 26 and capable of suppressing an increase in electric resistance at the bonding interface between the thermoelectric conversion element 11 and the first electrode portion 25, suppressing an increase in the internal resistance of the thermoelectric conversion module, and stably maintaining excellent thermoelectric efficiency.

In addition, since the first Ag plating layer 26 formed on the surface of the first electrode portion 25 and the thermoelectric conversion element 11 are bonded via the Ag bonding material (the Ag paste 48) containing Ag, it is possible to reliably bond the first electrode portion 25 and the thermoelectric conversion element 11 to each other.

In addition, in the present embodiment, in the Ag plating layer forming step S02, since the second Ag plating layer 36 is directly formed without forming a Ni plating layer on the surface of the second electrode portion 35 opposite to the second insulating layer 31, it is possible to produce the thermoelectric conversion module 10 having no Ni layer present between the second electrode portion 35 and the second Ag plating layer 36 and capable of suppressing an increase in electric resistance at the bonding interface between the thermoelectric conversion element 11 and the second electrode portion 35, suppressing an increase in the internal resistance of the thermoelectric conversion module 10, and stably maintaining excellent thermoelectric efficiency.

In addition, since the second Ag plating layer 36 formed on the surface of the second electrode portion 35 and the thermoelectric conversion element 11 are bonded via the Ag bonding material (the Ag paste 58) containing Ag, it is possible to reliably bond the second electrode portion 35 and the thermoelectric conversion element 11 to each other.

While the embodiment of the present invention has been described above, the present invention is not limited thereto and can be appropriately modified without departing from the technical idea of the invention.

For example, in the present embodiment, the Ag paste has been provided as an exemplary example of the Ag bonding material containing Ag, but the Ag bonding material is not limited thereto, and a silver oxide paste containing silver oxide and a reducing agent may be used. In addition, as the Ag particles, a nano Ag paste having a particle size of nanometers may be used.

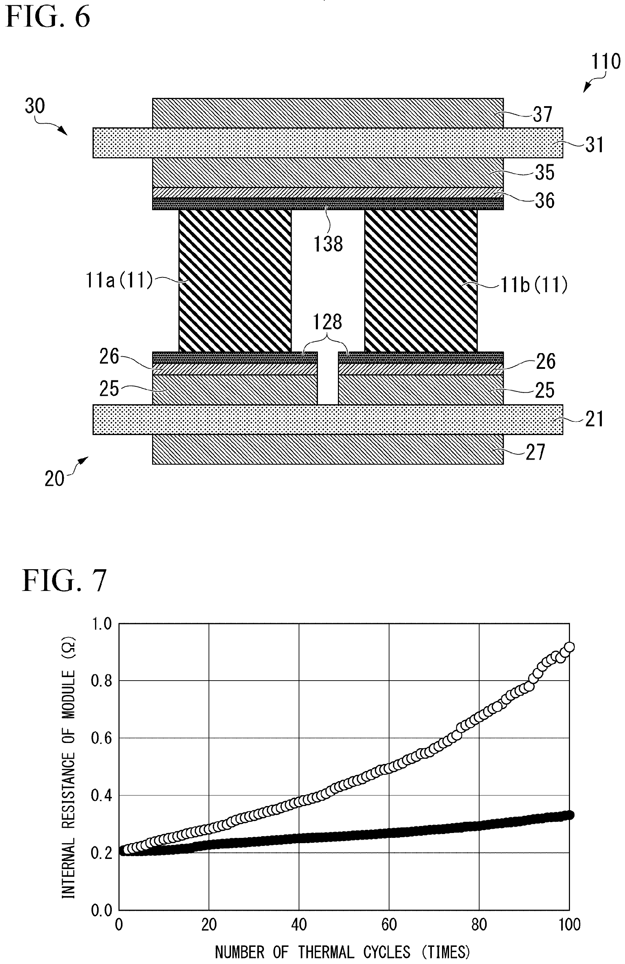

In addition, in the present embodiment, the first sintered silver layer 28 and the second sintered silver layer 38, which are sintered bodies of the Ag paste, are described as being formed in the regions where the thermoelectric conversion elements are disposed, but the first sintered silver layer 28 and the second sintered silver layer 38 are not limited thereto. As illustrated in Fig. 6, a thermoelectric conversion module 110 having a structure in which a first sintered silver layer 128 and a second sintered silver layer 138 are respectively formed on the entire surfaces of the first electrode portion 25 and the second electrode portion 35 may be provided.

In addition, in the present embodiment, the second insulating circuit board is described as being disposed as the second heat transfer plate 30 on the other end side of the thermoelectric conversion element 11, but the second heat transfer plate 30 is not limited thereto. For example, the second heat transfer plate may be configured by disposing the second electrode portion on the other end side of the thermoelectric conversion elements 11, laminating an insulating board, and pressing the insulating board in the lamination direction.

[Examples]

A confirmatory experiment performed to confirm effectiveness of the present invention will be described.

A thermoelectric conversion module was produced by the same method as in the above-described embodiment.

As the thermoelectric conversion element, a silicon germanium element in which a 3 mm × 3 mm × 5 mmt metallized layer with a Au outermost surface was formed was used, and 12 PN pairs were used.

As an insulating layer, aluminum nitride having a thickness of 0.635 mm was used. A rolled plate of oxygen-free copper having a thickness of 0.2 mm was bonded to one surface of this insulating layer to form an electrode portion, and a rolled plate of oxygen-free copper having a thickness of 0.2 mm was bonded to the other surface of the insulating layer to form a radiating layer. Accordingly, a first heat transfer plate (first insulating circuit board) and a second heat transfer plate (second insulating circuit board) were formed.

In the example of the present invention, a Ag plating layer was formed on the surface of the electrode portion. In a comparative example, a Ni plating layer having a thickness shown in Table 1 was formed on the surface of an electrode portion, and a Ag plating layer was further formed thereon.

The above-mentioned insulating circuit boards were respectively disposed on one end side and the other end side of the above-mentioned thermoelectric conversion element, a Ag paste was applied between the thermoelectric conversion element and the electrode portion as in the above-mentioned embodiment and is pressurized and heated, and the Ag paste was sintered to bond the electrode portion and the thermoelectric conversion element to each other. Accordingly, a thermoelectric conversion module was produced.

Regarding the obtained thermoelectric conversion module, measurement of initial resistance, measurement of resistance after the application of thermal cycles, and observation of interface were performed as follows.

(Initial Resistance)

The temperature of the first heat transfer plate side (high temperature side) of the produced thermoelectric conversion module was set to 450°C, and the temperature of the second heat transfer plate side (low temperature side) was set to 80°C. A state where the temperature difference as described above was given, a variable resistor was installed between output terminals of the thermoelectric conversion module, the current value and the voltage value were measured while changing the resistance, and a graph with the horizontal axis representing the current value and the vertical axis representing the voltage value was created. In this graph, the voltage value when the current value was 0 was taken as an open circuit voltage, and the current value when the voltage value was 0 was taken as a maximum current. In this graph, the open circuit voltage and the maximum current were connected by a straight line, the slope of the straight line was taken as the initial resistance of the thermoelectric conversion module. Table 1 shows evaluation results.

(Electric Resistance after Application of Thermal Cycles)

The low temperature side was fixed at 80°C, and the high temperature side was subjected to 100 thermal cycles between 450°C and 150°C. The above-mentioned thermal cycles were applied, and the electric resistance was measured by the above-mentioned method for each cycle. Table 7 shows measurement results. White circles are comparative examples and black circles are examples of the present invention. In addition, the electric resistance after applying 100 thermal cycles and the ratio to the initial resistance were evaluated. Table 1 shows evaluation results.

(Observation of Interface)

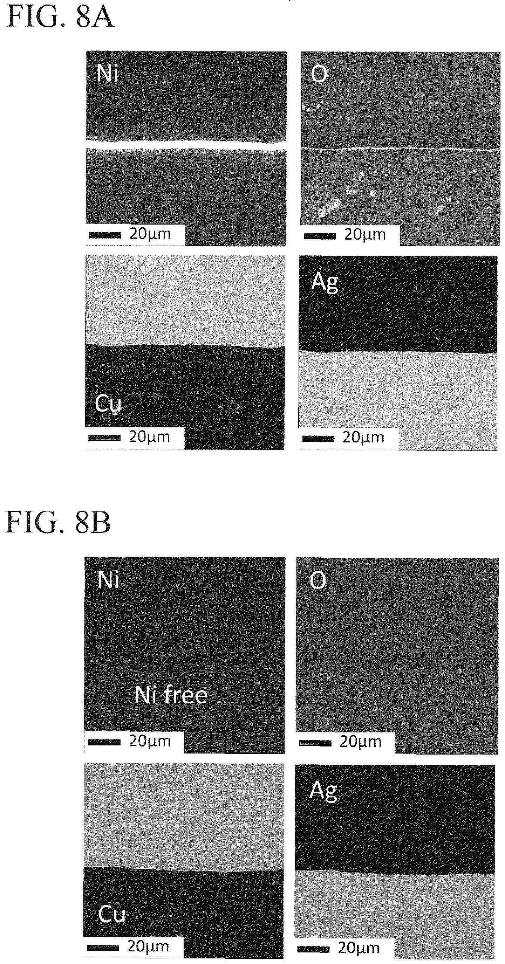

The interface between the electrode portion on the high temperature side and the thermoelectric conversion element of the thermoelectric conversion module of the example of the present invention and the comparative example after applying 100 thermal cycles was observed. By a scanning electron microscope (FE-EPMA JXA-8530F manufactured by JEOL Ltd.), an electron beam with a current amount of 50 nA was irradiated by FE-EPMA with an accelerating voltage of 15 kV to scan a 150 $\mu$m square range around the interface, the distribution of each element was examined from the generated characteristic X-rays, and the element mapping of each of Ni, O, Cu, and Ag was obtained. Figs. 8A and 8B show evaluation results. Fig. 8A shows a comparative example, and Fig. 8B shows an example of the present invention.

In Figs. 8A and 8B, portions observed as white indicate positions where each element was distributed.

[Table 1]

| | Ni plating layer | Internal resistance | | |
|---|---|---|---|---|
| | Thickness ($\mu$m) | Initial ($\Omega$) | After thermal cycles ($\Omega$) | Internal resistance increase rate (%) |
| Example of the present invention | Absent | 0.21 | 0.33 | $5.7 \times 10^1$ |
| Comparative Example | 5 | 0.21 | 0.92 | $3.4 \times 10^2$ |

In the comparative example in which the Ni plating layer was formed, as shown in Fig. 7, the electric resistance increased as the number of thermal cycles increased. In addition, the electric resistance (internal resistance) after applying 100 thermal cycles was increased, and the internal resistance increase rate was increased to $3.4 \times 10^2$%. In addition, as shown in Fig. 8A, it was confirmed that Ni was present in the form of a layer at the bonding interface, and O was present in the form of a layer together with the Ni. It is presumed that the internal resistance was increased by nickel oxide in the form of a layer.

Contrary to this, in the example of the present invention in which the Ag plating layer was directly formed on the surface of the electrode portion without forming the Ni plating layer, as shown in Fig. 7, the electric resistance (internal resistance) was not significantly increased even if the number of thermal cycles increased. In addition, the electric resistance after 100 thermal cycles were applied was relatively low, and the internal resistance increase rate was $5.7 \times 10^1$%. In addition, as shown in Fig. 8B, Ni was not present at the bonding interface, and O was not present in the form of a layer.

From the above, according to the present invention, it was confirmed that it is possible to provide a thermoelectric conversion module capable of suppressing an increase in the electric resistance at the bonding interface between the thermoelectric conversion element and the electrode portion even in use under the condition that temperature cycles are applied, suppressing an increase in the internal resistance of the thermoelectric conversion module, and stably maintaining excellent thermoelectric efficiency.

[Reference Signs List]

10 Thermoelectric conversion module
11 Thermoelectric conversion element
20 First heat transfer plate (first insulating circuit board)
21 First insulating layer
25 First electrode portion
30 Second heat transfer plate (second insulating circuit board)
31 Second insulating layer
35 Second electrode portion

**Claims**

1.   A thermoelectric conversion module comprising:

a plurality of thermoelectric conversion elements;
a first heat transfer plate having a first electrode portion disposed on one end side of the plurality of thermoelectric conversion elements; and
a second heat transfer plate having a second electrode portion disposed on the other end side of the plurality of thermoelectric conversion elements,
wherein the plurality of thermoelectric conversion elements are electrically connected to each other via the first electrode portion and the second electrode portion,
the first heat transfer plate disposed on the one end side of the thermoelectric conversion elements is formed from a first insulating circuit board provided with a first insulating layer and the first electrode portion made of copper or a copper alloy formed on one surface of the first insulating layer,
a Ag plating layer is directly formed on a surface of the first electrode portion opposite to the first insulating layer, and a Ni layer is not present between the first electrode portion and the Ag plating layer, and
the Ag plating layer and the thermoelectric conversion element are bonded to each other via a sintered body of Ag.

2. The thermoelectric conversion module according to claim 1,
wherein an internal resistance increase rate of the thermoelectric conversion module is 60% or less after applying 100 thermal cycles from 450°C to 150°C to a first heat transfer plate side while a second heat transfer plate side is fixed at 80°C in the air.

3. A method for producing a thermoelectric conversion module,

wherein the thermoelectric conversion module includes
a plurality of thermoelectric conversion elements,
a first heat transfer plate having a first electrode portion disposed on one end side of the plurality of thermoelectric conversion elements, and
a second heat transfer plate having a second electrode portion disposed on the other end side of the plurality of thermoelectric conversion elements,
wherein the plurality of the thermoelectric conversion elements are electrically connected to each other via the first electrode portion and the second electrode portion, and
the first heat transfer plate disposed on the one end side of the thermoelectric conversion elements is formed from a first insulating circuit board provided with a first insulating layer and the first electrode portion made of copper or a copper alloy formed on one surface of the first insulating layer,
the method comprising:

a Ag plating step of directly forming a Ag plating layer on a surface of the first electrode portion opposite to the first insulating layer without forming a Ni plating layer;
a laminating step of laminating the thermoelectric conversion element on a surface of the Ag plating layer of the first insulating circuit board via a Ag bonding material containing Ag; and
a thermoelectric conversion element bonding step of bonding the thermoelectric conversion element by pressurizing the thermoelectric conversion element and the first insulating circuit board in a lamination direction and heating the thermoelectric conversion element and the first insulating circuit board.

## FIG. 1

## FIG. 2

# FIG. 3

```
┌──────────────────────────────────────────┐
│         COPPER PLATE BONDING STEP          │ ～S01
└──────────────────────────────────────────┘
                      │
                      ▼
┌──────────────────────────────────────────┐
│        Ag PLATING LAYER FORMING STEP       │ ～S02
└──────────────────────────────────────────┘
                      │
                      ▼
┌──────────────────────────────────────────┐
│     Ag BONDING MATERIAL DISPOSING STEP     │ ～S03
└──────────────────────────────────────────┘
                      │
                      ▼
┌──────────────────────────────────────────┐
│               LAMINATING STEP              │ ～S04
└──────────────────────────────────────────┘
                      │
                      ▼
┌──────────────────────────────────────────┐
│ THERMOELECTRIC CONVERSION ELEMENT BONDING STEP │ ～S05
└──────────────────────────────────────────┘
                      │
                      ▼
╭──────────────────────────────────────────╮
│       THERMOELECTRIC CONVERSION MODULE     │
╰──────────────────────────────────────────╯
```

# FIG. 4

## FIG. 5

(a)

(b)

FIG. 6

FIG. 7

# FIG. 8A

# FIG. 8B

**INTERNATIONAL SEARCH REPORT**

International application No.

PCT/JP2019/022915

A. CLASSIFICATION OF SUBJECT MATTER
Int.Cl. H01L35/08(2006.01)i, H01L35/34(2006.01)i

According to International Patent Classification (IPC) or to both national classification and IPC

B. FIELDS SEARCHED

Minimum documentation searched (classification system followed by classification symbols)
Int.Cl. H01L35/08, H01L35/34

Documentation searched other than minimum documentation to the extent that such documents are included in the fields searched
Published examined utility model applications of Japan     1922–1996
Published unexamined utility model applications of Japan   1971–2019
Registered utility model specifications of Japan           1996–2019
Published registered utility model applications of Japan    1994–2019

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2017-059823 A (MITSUBISHI MATERIALS CORP.) 23 March 2017, paragraphs [0030], [0068]-[0083], [0095], fig. 7-8 & US 2019/0058101 A1, paragraphs [0041], [0079]-[0094], [0106], fig. 7-8 & WO 2017/047627 A1 & EP 3352233 A1 & TW 201725764 A & CN 108028306 A & KR 10-2018-0056681 A | 1-3 |
| A | US 2018/0033938 A1 (LG CHEM, LTD.) 01 February 2018, entire text, all drawings & WO 2017/014584 A1, entire text, all drawings & EP 3244461 A1 & KR 10-2017-0012119 A & CN 107251246 A | 1-3 |
| A | JP 2001-068746 A (SEIKO INSTRUMENTS INC.) 16 March 2001, entire text, all drawings & US 6410840 B1, entire text, all drawings & EP 1079445 A2 | 1-3 |

☐ Further documents are listed in the continuation of Box C.          ☐ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| 15 August 2019 (15.08.2019) | 27 August 2019 (27.08.2019) |

| Name and mailing address of the ISA/ | Authorized officer |
|---|---|
| Japan Patent Office | |
| 3-4-3, Kasumigaseki, Chiyoda-ku, | |
| Tokyo 100-8915, Japan | Telephone No. |

Form PCT/ISA/210 (second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2018115920 A
- JP 4363958 B

- JP 2010109054 A